Europäisches Patentamt

European Patent Office

Office européen des brevets

(11) Numéro de publication: **0 254 609**
**A1**

(12) **DEMANDE DE BREVET EUROPEEN**

(21) Numéro de dépôt: **87401456.6**

(22) Date de dépôt: **24.06.87**

(51) Int. Cl.4: **H 01 L 29/28**
**H 01 B 1/12**

(30) Priorité: **25.06.86 FR 8609204**

(43) Date de publication de la demande:
**27.01.88 Bulletin 88/04**

(84) Etats contractants désignés:
**AT BE CH DE ES GB GR IT LI LU NL SE**

(71) Demandeur: **UNIVERSITE DE LIMOGES**
**Allée André Maurois**
**F-87065 LIMOGES Cedex (FR)**

(72) Inventeur: **Moliton, André**
**La Boilerie**
**F-87430 Verneuil Sur Vienne (FR)**

**Duroux, Jean-Luc**
**3, Impasse Benoist du Buis**
**F-87270 Couzeix (FR)**

(74) Mandataire: **Armengaud Ainé, Alain**
**Cabinet ARMENGAUD AINE 3 Avenue Bugeaud**
**F-75116 Paris (FR)**

(54) **Procédé de réalisation de semi-conducteurs polymères.**

(57) Procédé de réalisation de semi-conducteurs polymères par implantation d'ions, caractérisé en ce qu'il consiste à doper des polymères électro-actifs stables à l'aide d'ions de rayons adaptés pour diffuser à l'intérieur des fibrilles des polymères, avec une énergie d'implantation relativement faible, le seuil supérieur étant d'autant plus petit que le diamètre de l'ion est petit.

EP 0 254 609 A1

Bundesdruckerei Berlin

## Description

### Procédé de réalisation de semi-conducteurs polymères

La présente invention est relative à la fabrication de semi-conducteurs polymères par implantation d'ions.

On a récemment tenté d'effectuer des implantations d'ions dans des matériaux polymères électro-actifs. On pourra, à cet égard, se reporter aux travaux effectués par H. Mazurek et al, au MIT (Etats-Unis), et dont il est rendu compte dans la publication américaine J. Polym., 21, 537 (1983). Ces travaux ont été réalisés avec une énergie élevée, supérieure à 100 keV, sans effet vraiment spécifique des ions. Par ailleurs (N. KOSHIDA et al., Appl. Phys. Lett., 45, 436 (1984), d'autres expériences ont été effectuées sur des polymères non stables à l'aire libre, tel que le polyacétylène ; elles ont donné lieu à un dopage dont la stabilité est insuffisante pour une utilisation normale (au bout de 37 jours, il n'était plus possible de relever des caractéristiques courant-tension). On pense que la conduction ou la semi-conduction ainsi obtenue est de nature ionique, et non attribuable à la nature chimique de l'ion implanté, seule la taille de l'ion (et non sa nature), intervenant sur le résultat de la conductivité finale. On est donc amené à penser que l'origine de la conductivité est liée aux endommagements du matériau polymère par les ions incidents aux hautes énergies, et les travaux de la titulaire ont révélé qu'aux basses énergies, on obtenait un dopage qui dépendait de la nature chimique de l'ion implanté.

En conséquence, cette invention a pour objet un procédé de réalisation de semi-conducteurs polymères par implantation d'ions, caractérisé en ce qu'il consiste à doper des polymères électro-actifs stables à l'aide d'ions de rayon adapté pour diffuser à l'intérieur des fibrilles des polymères, avec une énergie d'implantation relativement faible, inférieure à 50 keV.

Selon l'invention, le polymère utilisé est le polyparaphénylène ou du sulfure de poly-p-phénylène, ces deux polymères électro-actifs étant stables à l'air libre.

Selon l'invention, le dopage est effectué à l'aide d'ions alcalins ou alcalino-terreux pour obtenir une semi-conduction du type n, ou à l'aide d'ions halogènes, afin d'obtenir une semi-conduction de type p.

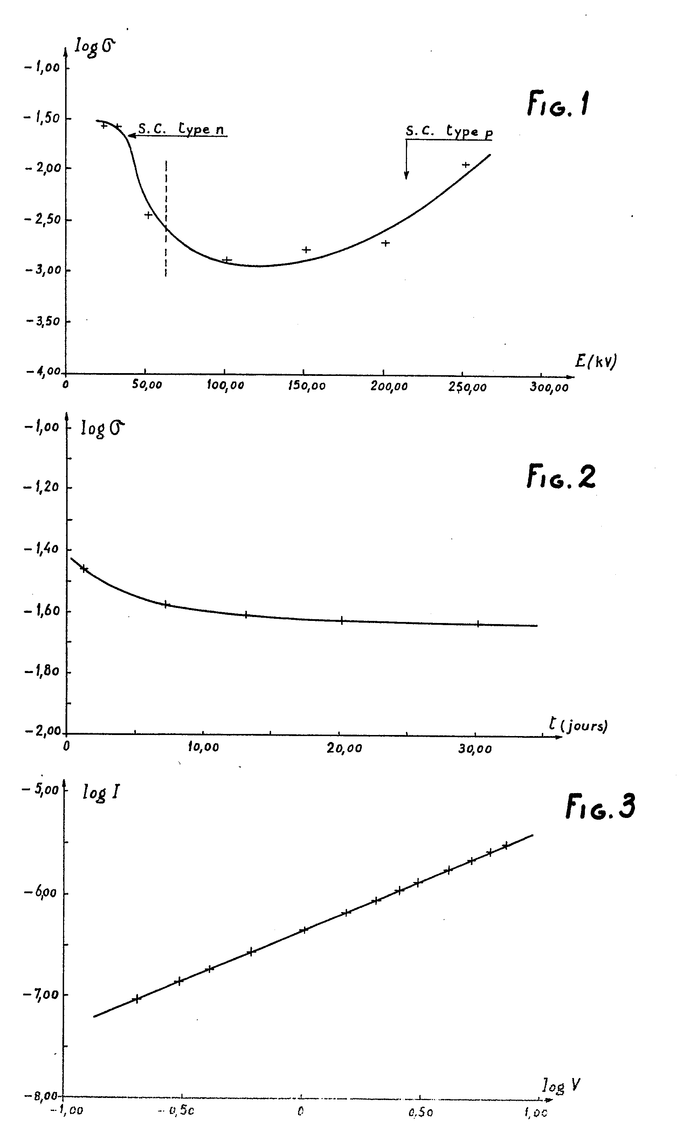

Comme on le comprend, l'invention permet de réaliser un dopage de nature électronique grâce à une implantation à basse énergie d'ions de rayon bien adapté pour pénétrer les fibrilles du polymère électro-actif, stable à l'air libre, choisi pour ce dopage, le choix d'une énergie d'implantation suffisament faible évitant de créer une semi-conduction par endommagement. Sur la figure 2 du dessin annexé, on a représenté la conductivité (log σ) du polyparaphénylène en fonction de l'énergie E de l'ion incident.

On a donné ci-après à titre d'exemple non limitatif un mode de mise en oeuvre du procédé de l'invention, permettant de réaliser un semi-conducteur polymère de type n.

Ce semi-conducteur a été obtenu par une implantation d'ions K+ (de diamètre voisin de 3A) dans une plaquette compactée de polyparaphénylène, dans les conditions suivantes :
- énergie des ions incidents ......................... 30 keV
- densité du courant d'ions incidents .. 1,11 µA/cm²;
- dose déposée .................................$10^{16}$ ions/cm²

Afin de montrer la stabilité du semi-conducteur polymère finalement obtenu, on a représenté sur le dessin annexé :
- En figure 2, la courbe d'évolution de la conductivité du polyparaphénylène dopé avec des ions K+ en fonction du temps : log σ = f(t), t étant donné en jours, cette courbe montrant que, dès le dixième jour on a obtenu la stabilité finale ;
- En figure 3, la caractéristique tension-courant : I = f (V) du semi-conducteur ainsi obtenu, cette courbe ayant été tracée au bout de 20 jours. Elle montre le bon fonctionnement du semi-conducteur.

Comme on l'a indiqué précédemment, on obtient selon l'invention des semi-conducteurs de type n par implantation d'ions alcalins ou alcalino-terreux, et on obtient une semi-conduction de type p en implantant des ions halogènes, notamment Br+. On obtient par ailleurs les mêmes résultats avec un polymère constitué par du sulfure de poly-p-phénylène ou par du P.P.V.

Dans tous les cas, on constate que la semi-conduction est d'autant plus élevée que la masse de l'ion implantée est élevée.

L'invention permet de réaliser un semi-conducteur organique polymère permettant de constituer des composants polymères (jonctions, transistors, etc,) offrant notamment les avantages suivants :
- Obtention d'une semi-conduction électronique utilisable dans des composants ;
- Stabilité à l'air libre de la semi-conduction, contrairement au polyacéthylène par exemple ;
- Stabilité dans le temps de la semi-conduction, ce qui n'est pas le cas d'une semi-conduction obtenue par dopage chimique en phase vapeur, par exemple.

Il demeure bien entendu que cette invention n'est pas limitée aux exemples de réalisation décrits ici mais qu'elle en englobe toutes les variantes.

### Revendications

1- Procédé de réalisation de semi-conducteurs polymères par implantation d'ions, caractérisé en ce qu'il consiste à doper des polymères électro-actifs stables à l'aide d'ions de rayons adaptés pour diffuser à l'intérieur des fibrilles des polymères, avec une énergie d'implantation relativement faible, le seuil supérieur étant d'autant plus petit que le diamètre de l'ion est petit.

2- Procédé selon la revendication 1, caractérisé en ce que le polymère dopé est du polyparaphénylène.

3- Procédé selon la revendication 1, caractérisé en ce que le polymère dopé est du sulfure de poly-p-phénylène.

4- Procédé selon l'une quelconque des revendications précédentes, caractérisé en ce qu'on effectue une implantation d'ions alcalins ou alcalino-terreux, de préférence d'ions K+, Rb+, Cs+, pour obtenir une semi-conduction de type n.

5- Procédé selon la revendication 4, caractérisé en ce que l'énergie d'implantation est de l'ordre de 50 keV, pour les ions K+.

6- Procédé selon la revendication 4, caractérisé en ce que l'énergie d'implantation est de l'ordre de 100 keV, pour les ions Cs+.

7- Procédé selon l'une quelconque des revendications 1 à 3, caractérisé en ce qu'on effectue une implantation d'ions halogènes, de préférence d'ions Br+, I+, pour obtenir une semi-conduction de type p.

0254609

Fig. 1

Fig. 2

Fig. 3

**Office européen des brevets**

**RAPPORT DE RECHERCHE EUROPEENNE**

Numéro de la demande

EP  87 40 1456

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 526 832 (USA-SECRETARY OF THE NAVY) <br> * Colonne 3, lignes 8-26; colonne 5, lignes 50-53; revendications 1,2 * | 1,3,7 | H 01 L 29/28 <br> H 01 B 1/12 |
| | --- | | |
| A | US-A-4 491 605 (MIT) <br> * Revendications 1-3,7-12; colonne 2, lignes 47-51 * | 1-3,7 | |
| | --- | | |
| A | JOURNAL OF APPLIED PHYSICS, vol. 59, no. 4, 15 février 1986, pages 1111-1116, American Institute of Physics, New York, US; J. BARTKO et al.: "Highly conductive poly(phenylene sulfide) prepared by high-energy ion irradiation" | 1,3,4, 7 | |
| | --- | | **DOMAINES TECHNIQUES RECHERCHES (Int. Cl.4)** |
| A | EP-A-0 016 305 (ALLIED CHEMICAL CORP.) <br> * Revendications 1,5-7 * | 1,2,4 | H 01 L <br> H 01 B |
| | --- | | |
| A | PATENT ABSTRACTS OF JAPAN, vol. 9, no. 321 (E-367)[2044], 17 décembre 1985; & JP-A-60 154 682 (SHOWA DENKO K.K.) 14-08-1985 | | |
| | --- | | |
| A | EP-A-0 089 575 (BASF AG) | | |
| | ----- | | |

Le présent rapport de recherche a été établi pour toutes les revendications

| Lieu de la recherche <br> LA HAYE | Date d'achèvement de la recherche <br> 19-10-1987 | Examinateur <br> VANCRAEYNEST F.H. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille, document correspondant

OEB Form 1503 03 82